# EUROPEAN PATENT APPLICATION

(11) **EP 4 600 702 A1**
(43) Date of publication of application: **13.08.2025**
(21) Application number: 24275011.5
(22) Date of filing: 08.02.2024
(51) Int. Cl.: G01V 3/08, G01C 17/02, G01R 33/26, G01V 3/165, G01V 3/38, G01V 3/40

(54) **MAGNETIC FIELD MEASUREMENTS**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

There is provided a method of filtering magnetic field measurements generated by an optically pumped magnetometer mounted to an unmanned aerial vehicle. The method comprises filtering the magnetic field measurements to obtain filtered magnetic field measurements which exclude a contribution from a rotor of the unmanned aerial vehicle. The method also includes detecting a magnetic beacon based on the filtered magnetic field measurements. Also provided are devices configured to perform this method.

## Description

### FIELD

The present invention relates to magnetic field measurements, and in particular to a method of filtering magnetic field measurements generated by an optically pumped magnetometer mounted to an unmanned aerial vehicle (UAV). The present invention also relates to devices configured to perform this method.

### BACKGROUND

Sensors mounted to or otherwise incorporated into aerial vehicles can be used to determine magnetic field measurements. These magnetic field measurements can be used to detect objects that generate magnetic fields, to measure the magnetic field of the Earth to facilitate navigation, and/or for the purposes of communication.

Traditional magnetometers are typically large, heavy and relatively insensitive. Such traditional magnetometers may be inductive magnetometers, which generate measurements of varying magnetic fields through detecting the electric current induced in a coil according to Faraday's law of induction. The size and weight of these traditional magnetometers limit the types of aerial vehicles which they are suitable for mounting to. The relative insensitivity of these traditional magnetometers limits the applications which they can be used for.

An optically pumped magnetometer (OPM) is a form of quantum sensor which is capable of generating highly sensitive magnetic field measurements while being relatively small and light. The smaller size and weight of OPMs enables them to be mounted to a greater range of aerial vehicles, i.e. to smaller/lower power aerial vehicles, since their size and weight is not prohibitive.

However, while the increased sensitivity of OPMs is in principle useful for detection, this high sensitivity means that measurement signals comprise a large contribution from environmental/background fields, which makes determining usable readings difficult. This may be especially challenging when an OPM is mounted to a smaller aerial vehicle, in which case the OPM may be relatively close to moving metallic components of the aerial vehicle such that the dominant magnetic field measured by the OPM may be generated by the aerial vehicle itself rather than the objects or area which it is intended to detect or survey. Existing techniques for dealing with general platform noise such as spectral filtering, Fourier analysis or mathematical algorithm treatments would not be suitable for application to an OPM on such an aerial vehicle due to not providing the high sensitivity needed. Previous filtering techniques which have been applied to inductive magnetometers would not be suitable for taking into account the dynamic response of an atomic magnetometer such as an OPM, which has a very different profile to the response of an inductive magnetometer.

As such, the size/weight/insensitivity of traditional magnetometers has prevented their application to smaller aerial vehicles and to purposes requiring high sensitivity. The high sensitivity of OPMs, especially in the changing electromagnetic environment of an aerial vehicle, and the lack of suitable techniques to compensate for this, has prevented their use in aerial vehicle-mounted, high-sensitivity applications.

The present invention seeks to address these and other disadvantages encountered in the prior art.

### SUMMARY

According to a first aspect, there is provided a method of filtering magnetic field measurements generated by an optically pumped magnetometer mounted to an unmanned aerial vehicle, the method comprising: filtering the magnetic field measurements to obtain filtered magnetic field measurements which exclude a contribution from a rotor of the unmanned aerial vehicle; and detecting a magnetic beacon based on the filtered magnetic field measurements.

Optional features of the first aspect will now be described. The detecting of the magnetic beacon may comprise determining an amplitude of a signal in the filtered magnetic field measurements. The signal may correspond to a transmission frequency of the magnetic beacon. The transmission frequency of the magnetic beacon may be lower than the frequencies comprised in the contribution from the rotor. The transmission frequency of the beacon may be approximately constant with time. The transmission frequency of the beacon may be approximately 5 Hz. The method may comprise determining a distance between the unmanned aerial vehicle and the magnetic beacon based on the amplitude of the signal. The filtering of the magnetic field measurements may comprise demodulating the magnetic field measurements. The filtering of the magnetic field measurements may comprise applying a bandpass filter to the magnetic field measurements, the bandpass filter being configured to pass signals at a transmission frequency of the magnetic beacon. The filtering of the magnetic field measurements may comprise applying a finite impulse response filter to the magnetic field measurements. The method may comprise correcting the magnetic field measurements for time-based jitter. The method may comprise filtering the magnetic field measurements to remove the geomagnetic field at the location of the unmanned aerial vehicle from the magnetic field measurements. The contribution to the magnetic field measurements from the rotor may have inconsistent phase and/or time-varying frequencies.

According to a second aspect, there is provided a control device configured to filter magnetic field measurements generated by an optically pumped magnetometer mounted to an unmanned aerial vehicle, the control device comprising: a processor; and instructions which, when executed by the processor, cause the processor to: filter the magnetic field measurements to obtain filtered magnetic field measurements which exclude a contribution from a rotor of the unmanned aerial vehicle; and detect a magnetic beacon based on the filtered magnetic field measurements.

Optional features of the second aspect will now be described. The detecting of the magnetic beacon may comprise determining an amplitude of a signal in the filtered magnetic field measurements. The signal may correspond to a transmission frequency of the magnetic beacon. The transmission frequency of the magnetic beacon may be lower than the frequencies comprised in the contribution from the rotor. The transmission frequency of the beacon may be approximately constant with time. The transmission frequency of the beacon may be approximately 5 Hz. The instructions when executed by the processor may further cause the processor to determine a distance between the unmanned aerial vehicle and the magnetic beacon based on the amplitude of the signal. The filtering of the magnetic field measurements may comprise demodulating the magnetic field measurements. The filtering of the magnetic field measurements may comprise applying a bandpass filter to the magnetic field measurements, the bandpass filter being configured to pass signals at a transmission frequency of the magnetic beacon. The filtering of the magnetic field measurements may comprise applying a finite impulse response filter to the magnetic field measurements. The instructions when executed by the processor may further cause the processor to correct the magnetic field measurements for time-based jitter. The instructions when executed by the processor may further cause the processor to filter the magnetic field measurements to remove the geomagnetic field at the location of the unmanned aerial vehicle from the magnetic field measurements. The contribution to the magnetic field measurements from the rotor may have inconsistent phase and/or time-varying frequencies.

According to third aspect, there is provided an unmanned aerial vehicle configured for use with a magnetic beacon, the unmanned aerial vehicle comprising: a rotor; an optically pumped magnetometer configured to generate magnetic field measurements; and a control device according to the second aspect described above.

### BRIEF DESCRIPTION OF THE FIGURES

Embodiments of the invention will now be described by way of example only with reference to the figures, in which:
Figure 1a shows a top-down view of an example unmanned aerial vehicle according to the current disclosure;
Figure 1b shows a side-on view of an example unmanned aerial vehicle according to the current disclosure;
Figure 2 shows an example OPM according to the current disclosure;
Figure 3 shows an example method according to the current disclosure; and
Figure 4 shows an example system for implementing the method according to Figure 3.

Like reference numerals are used for like components throughout the drawings.

### DETAILED DESCRIPTION

The current disclosure provides techniques for filtering magnetic field measurements generated by an OPM mounted to an unmanned aerial vehicle. These techniques are used in combination with a magnetic beacon, which the unmanned aerial vehicle detects using the OPM together with filtering techniques. According to the current disclosure, the magnetic field measurements are filtered to obtain filtered magnetic field measurements which exclude a contribution from a rotor of the unmanned aerial vehicle. In other words, the component of the local magnetic field measured by the OPM which is generated by the movement of the rotor is filtered out of the magnetic field measurements. Based on the filtered magnetic field measurements, the magnetic beacon is detected. In other words, the filtering enables the contribution to the magnetic field measurements from the magnetic beacon to be determined.

According to the techniques of the current disclosure, an OPM can be mounted to an unmanned aerial vehicle and the high sensitivity of the OPM can be fully utilised. This is because the combination of the filtering and the use with a magnetic beacon allow detection of the magnetic beacon with high sensitivity, without the magnetic field measurements being irretrievably dominated by the electromagnetic environment resulting from the OPM being mounted on the unmanned aerial vehicle.

Therefore, the techniques of the current disclosure can increase the versatility of both unmanned aerial vehicles and OPMs. The techniques of the current disclosure can also increase the sensitivity of aerial magnetic measurements. The techniques of the current disclosure can also increase the efficiency of aerial magnetic measurements through enabling use of smaller/lighter magnetometers and smaller/lighter aerial vehicles.

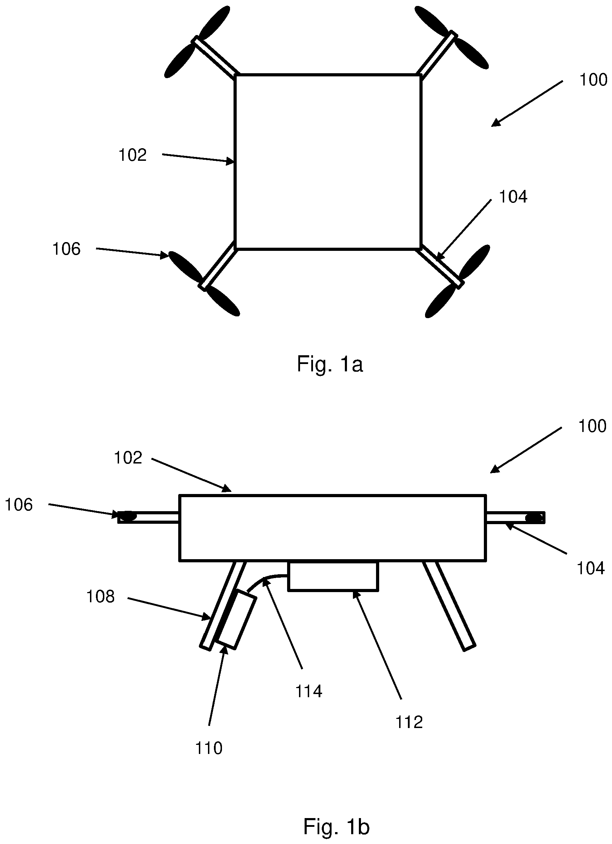

Figures 1a and 1b show an example unmanned aerial vehicle 100 according to the current disclosure. Figure 1a shows the unmanned aerial vehicle in a top-down view (i.e. from above), while Figure 1b shows the unmanned aerial vehicle 100 in a side-on view. The skilled person will be familiar with unmanned aerial vehicles, and the features and operation of the example unmanned aerial vehicle 100 will be set out briefly below.

The example unmanned aerial vehicle 100 comprises a body 102, one or more arms 104 and one or more rotors 106. The body 102 may comprise a housing encompassing control electronics, a battery, one or more sensors and/or one or more communication devices. One or more of the rotors 106 may be fixed to each of the arms 104. As depicted in Figure 1a, one rotor 106 may be fixed to each of four arms 104. Each rotor 106 may be coupled to a pivot point allowing rotation of the rotor 106 about this pivot point. The rotors 106 may be communicatively coupled to the components of the body 102, which may control the rotors 106 to rotate at instructed times and speeds. The lift provided by the rotation of the rotors 106 enables flight of the unmanned aerial vehicle 100. Rotation of the different rotors 106 at different speeds and/or in different directions enables steering of the unmanned aerial vehicle along a desired trajectory at a desired speed.

It will be appreciated that the current disclosure is not limited to any particular form of unmanned aerial vehicle. The current disclosure is applicable to unmanned aerial vehicles with different numbers and arrangements of rotors 106, arms 104 and bodies 102. The techniques for filtering out rotor noise as described herein are applicable to one rotor 106 or multiple rotors 106. While Figure 1b depicts each rotor 106 as having two rotor blades, each rotor 106 may comprise one, two, three, four, five, six or more rotor blades.

As depicted in Figure 1b, the example unmanned aerial vehicle 100 comprises one or more legs 108, which may be fixed to the body 102 and which may support the unmanned aerial vehicle 100 when it rests on a surface or platform, such as the ground. The unmanned aerial vehicle 100 comprises an OPM 110. The OPM 110 may be described as being comprised in the unmanned aerial vehicle 100 or as being mounted to the unmanned aerial vehicle 100. The OPM 110 may be mounted to one or more of the legs 108. In other examples, the OPM 110 may be mounted to the body 102. The OPM is configured to generate magnetic field measurements at the location of the OPM 110/unmanned aerial vehicle 100. Movement of the unmanned aerial vehicle 100 with time, and generation of magnetic field measurements at different times using the OPM 110, may be used to generate magnetic field measurements as a function of distance/location.

The OPM 110 may be coupled to control electronics and battery 112. The coupling 114 may be a wired connection (as shown in Figure 1b) or a wireless connection. The control electronics may send computer-executable instructions to the OPM 110, for example to control when measurements are taken, and may receive measurement data from the OPM 110 for storage or communication to the unmanned aerial vehicle 100 and/or ground-based systems. The battery may provide power to the OPM 110. In some examples, the control electronics and battery 112 may not be present, but rather the OPM 110 may be electronically and/or communicatively coupled to control electronics and battery of the unmanned aerial vehicle 100 itself. This may advantageously further reduce the size and weight of the unmanned aerial vehicle 100, avoiding duplication and added complexity.

The OPM 110 provides an accurate and precise measurement of the magnetic field at the location of the sensor head. This is achieved through resonant modulation of both the optical and magnetic resonances in a sample of alkali metal vapour (typically caesium or rubidium). For caesium-133 (133Cs) in a geomagnetic field of ~50 µT, the optical resonance is -335 THz (895 nm) and the magnetic (RF) resonance is -175 kHz. The alkali metal vapour can be hermetically sealed within a microfabricated cell, and the magnetic resonance signal is optically detected and demodulated at the magnetic resonance frequency. Phase changes in the detected magnetic resonance allow measurement of changes in the magnetic field.

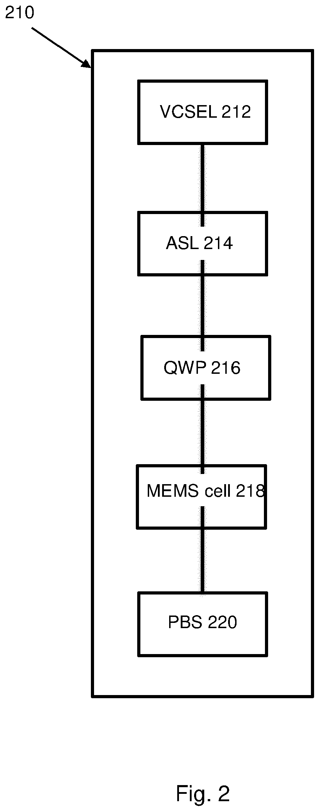

While the skilled person will be familiar with OPMs, components of an example OPM are depicted in Figure 2 by way of non-limiting example. The OPM 210 may correspond to OPM 110 shown in Figure 1b. The example OPM 210 may comprise one or more of a vertical-cavity surface-emitting laser (VCSEL) 212, an aspheric lens (ASL) 214, a quarter-wave plate (QWP) 216, a MEMS (microelectromechanical systems) cell 218, and a polarising beam splitter (PBS) 220. The VCSEL 212 may be configured to generate a laser beam. Suitable optical components, such as the ASL 214 and QWP 216, may be coupled between the VCSEL 212 and the MEMS cell 218. The MEMS cell 218 may comprise a MEMS cell heater for heating the MEMS cell 218 and a modulation coil. The PBS 220 may be configured to facilitate measurement of the resulting magnetic resonance signal. The OPM 210 may be combined with a digital signal processing platform which may digitise the magnetic resonance signal. An example OPM suitable for use with the current application is further described in: Ingleby, S., Griffin, P., Dyer, T. et al. A digital alkali spin maser. Sci Rep 12, 12888 (2022), which is incorporated by reference herein in its entirety. It will be appreciated that the current disclosure is not limited to the form of OPM depicted in Figure 2, but that the current disclosure is applicable to any form of OPM.

The OPM 210 can be used to generate magnetic field measurements, including to detect a magnetic beacon. A magnetic beacon can produce an oscillating field for localisation and range finding and can provide quantitative data for magnetic navigation. A magnetic beacon as used herein may comprise a transmission coil. The transmission coil may be square in shape, though other shapes of coil are possible and envisaged. By way of example, the transmission coil may be dimensioned to have sides of approximately 1 m and may have approximately 20 turns. The transmission coil may, by way of example, produce approximately 48 µT/A at the coil centre. In the far-field approximation, the resulting field is reduced by a factor of approximately eight times the distance d (in metres) from the coil cubed, *8d³.* Therefore, at 6 m distance, the field produced by a 1 A drive current may be approximately 28 nT. A function generator connected to the transmission coil may be used to provide drive current, power supply and amplifier. These may be provided, by way of example, at frequencies up to 1 kHz.

When an OPM 110 is mounted to an unmanned aerial vehicle 100, it may be close to moving metallic components of the unmanned aerial vehicle 100, e.g. to one or more rotors 106 (see Figure 1b). The OPM 110 may be far closer to the rotors 106 than to a magnetic beacon which it is desired to detect. Since the magnetic field generated by the magnetic beacon as measured by the OPM 110 decreases in proportion to the cube of their separation, for moderate separations the total magnetic field measured by the OPM 110 may be dominated by the contribution from the rotors 106 rather than by the contribution from the magnetic beacon. In addition, the contribution from the rotors 106 may typically not be phase coherent and may have a range of frequencies, which render previous approaches to filtering unsuitable for achieving high sensitivity. This may make it difficult to detect the magnetic beacon.

According to the current disclosure, filtering techniques applied to the magnetic field measurements, in combination with the use of a magnetic beacon, enable magnetic detection with high sensitivity. These techniques enable the intense spectral noise from the unmanned aerial vehicle 100 to be filtered out of the magnetic measurements.

The OPM 110 generates a signal corresponding to magnetic field measurements. This signal is demodulated to extract the contribution from the magnetic beacon, e.g. the amplitude of the contribution from the magnetic beacon. Demodulation involves extracting an information-bearing signal from a carrier wave. According to the current disclosure, the amplitude may be extracted, rather than the phase, because the background noise from the rotors 106 is at a large number of jumbled phases, which could coincide with the phase of the contribution from the magnetic beacon. Therefore, the focus on extracting the amplitude enables the accuracy of the filtered measurements to be improved.

The background noise from the rotors 106 may typically comprise a range of frequencies. It will be appreciated that one or more of the rotors 106 may vary its speed of rotation at different times, which itself may cause the background noise from the rotors 106 to comprise a range of different frequencies. Therefore, according to the current disclosure the acquired signal is demodulated at a frequency which is outside the range of frequencies generated by the rotors 106. The acquired signal is demodulated at the transmission frequency of the magnetic beacon. The amplitude of the signal at this frequency may thereby be obtained.

The magnetic beacon may operate with a transmission frequency lower than frequencies comprised in the contribution from the rotor 106. The magnetic beacon may operate with a transmission frequency which is constant with time. By way of non-limiting example, this transmission frequency may be approximately 5 Hz. Other transmission frequencies are possible and envisaged, for example 1 Hz, 2 Hz, 3 Hz, 4 Hz, 6 Hz, 7 Hz, 8 Hz, 9 Hz, 10 Hz, 15 Hz, 20 Hz, 30 Hz, 40 Hz, 50 Hz, 60 Hz, etc. It may be advantageous to select a relatively low transmission frequency, such as approximately 5 Hz, since with higher frequencies there may be increased spectral spread, with sideband formation. This may hinder the measurement of a narrowly defined peak and of a reliable amplitude of that peak, which may reduce the accuracy of determinations of distance to the magnetic beacon. Therefore, the use of a transmission frequency of approximately 5 Hz may increase the accuracy of detection of a magnetic beacon and of determination of distance to the magnetic beacon.

The amplitude of the magnetic beacon signal detected by the OPM may be obtained by demodulation of the OPM data at the beacon transmission frequency. The amplitude of the magnetic beacon signal detected by the OPM may be obtained by lock-in detection, which may be used to extract the signal in a defined frequency range around the transmission frequency of the OPM.

The filtering of the magnetic field measurements may include applying a bandpass filter to the magnetic field measurements. A bandpass filter is configured to pass frequencies within a particular range and attenuate/reject frequencies outside that range. The bandpass filter may be configured to pass frequencies at a transmission frequency of the magnetic beacon. The bandpass filter may be configured to reject/attenuate frequencies of the contribution from the rotor 106 of the UAV. The bandpass filter may be implemented as a finite impulse response (FIR) filter.

Though the background noise from the rotors 106 may have a higher frequency than the transmission frequency of the magnetic beacon, aliasing of the contribution from the rotors 106 is a possibility. This may occur due to under sampling of the contribution from the rotors 106, which may falsely indicate that the contribution from the rotors 106 has a lower frequency through missing at least some of the peaks and troughs of the contribution. This may be avoided through implementing a higher sampling rate (e.g. at a sampling rate above the Nyquist rate of the signal) and/or by using a low-pass filter to block frequencies above the Nyquist frequency of the sampling electronics.

The signal may be corrected for time base jitter. The OPM 110 may measure data at an internal clock rate which may not be constant with time. This time base jitter may be corrected for by not taking data at this internal clock rate, but by taking points regularly at constant intervals (e.g. of a microsecond) to give a resolution corresponding to the interval length and enable demodulation at that resolution. The removal of this time base jitter may advantageously reduce spectral spread and power loss to sideband formation, which may increase the accuracy of the detection of a magnetic beacon.

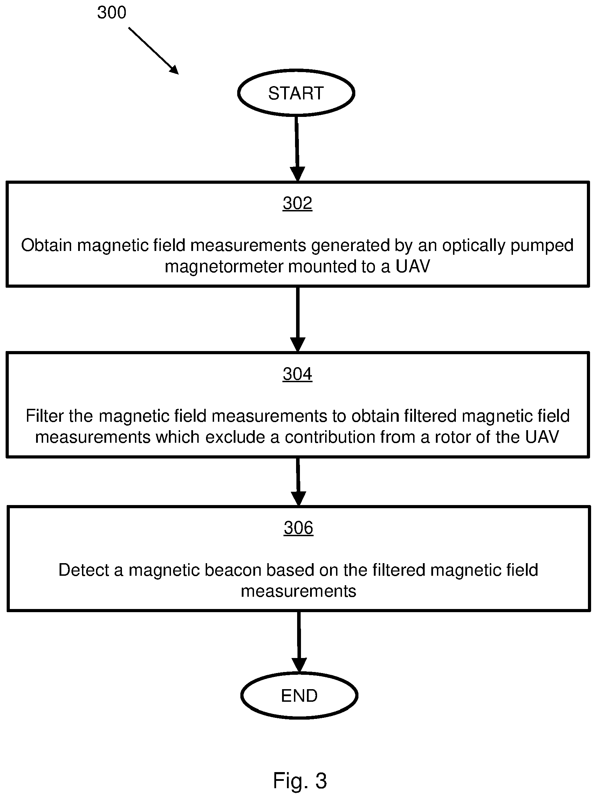

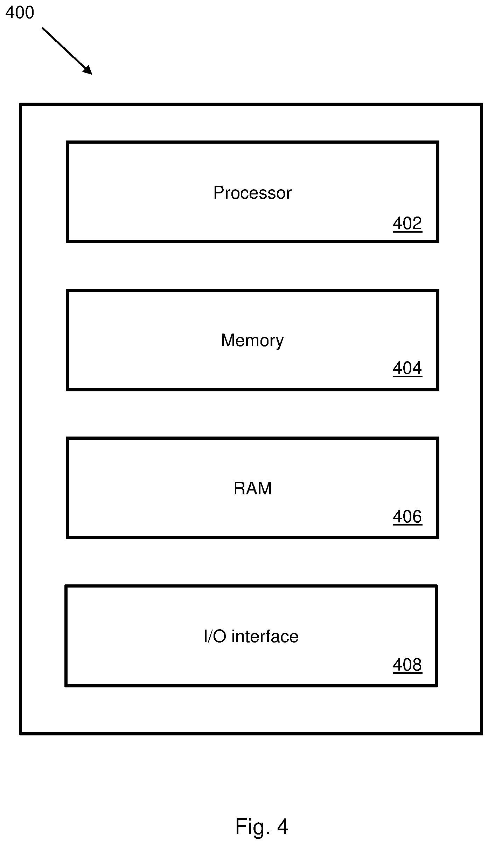

Figure 3 shows an example method according to the current disclosure. The method may be performed by a device/control device as described herein, for example by system 400 (see Figure 4), which may be ground-based or otherwise remote from the unmanned aerial vehicle, or may incorporated into or be mounted to the unmanned aerial vehicle, for example as part of control electronics and battery 112.

In a step 302, the method 300 may include obtaining magnetic field measurements generated by an optically pumped magnetometer 110, 210 mounted to an unmanned aerial vehicle 100. The measurements may be generated by the OPM 110, 210. The measurements may be transmitted from the OPM 110, 210 to the device/control device performing the method 300, by wired or wireless communication means, optionally via the control electronics and battery 112. In some examples, the magnetic field measurements may be obtained from an intermediate device, such as a data storage device.

In a step 304, the method 300 may include filtering the magnetic field measurements to obtain filtered magnetic field measurements which exclude a contribution from a rotor 106 of the unmanned aerial vehicle 100. In other words, this filtering removes from the magnetic field measurements a portion of the magnetic field measurements which is generated by or attributable to movement of the rotor 106 of the unmanned aerial vehicle 100. This filtering may include any one or combination of the techniques described herein.

In a step 306, the method 300 may include detecting a magnetic beacon based on the filtered magnetic field measurements. Step 306 may include determining an amplitude of a signal in the filtered magnetic field measurements, and this signal may correspond to a transmission frequency of the magnetic beacon. The distance from the OPM 110, 210 or from the unmanned aerial vehicle 100 to the magnetic beacon may be determined based on the amplitude of the signal. This determination may be based, for example, on using the fact that, in the far-field approximation, the magnetic field from the magnetic beacon is reduced by a factor of approximately eight times the distance d (in metres) from the coil cubed, *8d³.* A known magnetic field generated at the location of the beacon, and a known magnetic field measured at the location of the OPM 110, 210 may thereby be used to calculate the distance between the magnetic beacon and the OPM 110, 210.

It will be appreciated that one or more of the steps of method 300 may be omitted and that one or more additional steps may be incorporated into the method 300.

The filtering techniques set out in the current disclosure enable high sensitivity detection of a magnetic beacon from magnetic field measurements generated by an OPM 110, 210 in the noisy electromagnetic environment of an unmanned aerial vehicle 100. The filtering techniques described herein are optimised to enable this, for example through using knowledge of characteristics of the background noise which it is desired to exclude and/or through using of knowledge of the frequency of the magnetic beacon which it is desired to detect. These may be used, for example, in design/selection of the filtering operations applied to the magnetic field measurements as described herein.

In some examples, additional components of the unmanned aerial vehicle 100 may generate additional contributions to the magnetic field measurements generated by the OPM 110, 210. The techniques described herein may be adjusted to take this into account and to exclude such additional contributions in the filtering applied. For example, a magnetic field contribution at a specific frequency may be excluded through use of a notch filter configured to attenuate that frequency while passing other frequencies. Moreover, the transmission frequency of the magnetic beacon may be adjusted to avoid noisy parts of the spectrum, with the filtering techniques adapted in a corresponding manner. A magnetic field contribution which is intermittent may be filtered out by excluding data corresponding to times when this magnetic field contribution is present in the measurements.

The filtering applied to the magnetic field measurements to obtain the filtered magnetic field measurements may include excluding the Earth's field, i.e. the geomagnetic field, from the magnetic field measurements. For example, this may comprise subtracting the known or calculated magnetic field at the location of the unmanned aerial vehicle 100 from the magnetic field measurements.

In some examples, multiple OPMs 110, 210 may be mounted to or incorporated into the unmanned aerial vehicle 100. The multiple OPMs 110, 210 may have different mounting locations and/or different orientations. The multiple OPMs 110, 210 may increase the accuracy and reliability of detection of the magnetic beacon. For example, data from the multiple OPMs 110, 210 may be combined, which may increase the sensitivity and reduce the error margins of the resulting information, e.g. the distance to a magnetic beacon. The differing locations and/or orientations may lead to the different OPMs 110, 210 measuring different contributions from the rotors 106. In some examples, this may enable the contribution from the rotors 106 to be better resolved through selecting data from one of the OPMs 110, 210 or combining data from multiple of the OPMs 110, 210. Multiple OPMs 110, 210 may increase the reliability of the detection of the magnetic beacon through providing redundancy and providing additional sources of measurements in case a dead zone of one of the OPMs 110, 210 impacts the measurements.

The method according to Figure 3, as well as further operations described in the current disclosure, may be performed by a control device. The control device may optionally comprise or be coupled to one or more electronic components/circuits for implementing the method according to Figure 3, as well as further operations described in the current disclosure. For example, the control device may comprise or be coupled to a bandpass filter. As will be understood by the skilled person, the bandpass filter may comprise an arrangement of one or more of resistors, capacitors and inductors (passive bandpass filter), and/or may comprise an arrangement of one or more of a power supply, transistors, op-amps and integrated circuits (active bandpass filter).

Figure 4 shows a system 400 for implementing the method according to Figure 3, as well as further operations described in the current disclosure. As used herein, the system 400 may be described as a control device.

As shown, system 400 comprises a processor 402 and a memory 404, which may store computer-executable instructions for causing the processor 402 to perform the method of Figure 3. System 400 also includes a RAM 406 for storing signals, e.g. magnetic field measurements, received from the OPM 110, 210 during processing of the signals by the processor 402. Memory 404 may store the signals after processing by the processor 402, e.g. may store filtered magnetic field measurements. System 400 includes an input/output (I/O) interface 408 for receiving signals from the OPM 110, 210, and for sending signals to other devices communicatively coupled to the system 400.

It is to be understood that the above description is intended to be illustrative, and not restrictive. Many other implementations will be apparent to those of skill in the art upon reading and understanding the above description. Although the present disclosure has been described with reference to a specific example implementation, it will be recognized that the disclosure is not limited to the implementations described, but can be practiced with modification and alteration insofar as such modification(s) and alteration(s) remain within the scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

## Claims

1. A method of filtering magnetic field measurements generated by an optically pumped magnetometer (110, 210) mounted to an unmanned aerial vehicle (100), the method comprising:
filtering the magnetic field measurements to obtain filtered magnetic field measurements which exclude a contribution from a rotor (106) of the unmanned aerial vehicle; and
detecting a magnetic beacon based on the filtered magnetic field measurements.

2. The method according to claim 1, wherein detecting the magnetic beacon comprises determining an amplitude of a signal in the filtered magnetic field measurements.

3. The method according to claim 2, wherein the signal corresponds to a transmission frequency of the magnetic beacon.

4. The method according to claim 3, wherein the transmission frequency of the magnetic beacon is lower than the frequencies comprised in the contribution from the rotor (106).

5. The method according to claim 3 or claim 4, wherein the transmission frequency of the beacon is approximately constant with time.

6. The method according to any of claims 3-5, wherein the transmission frequency of the beacon is approximately 5 Hz.

7. The method according to any of claims 2-6, comprising determining a distance between the unmanned aerial vehicle (100) and the magnetic beacon based on the amplitude of the signal.

8. The method according to any preceding claim, wherein the filtering of the magnetic field measurements comprises demodulating the magnetic field measurements.

9. The method according to any preceding claim, wherein the filtering of the magnetic field measurements comprises applying a bandpass filter to the magnetic field measurements, the bandpass filter being configured to pass signals at a transmission frequency of the magnetic beacon.

10. The method according to any preceding claim, wherein the filtering of the magnetic field measurements comprises applying a finite impulse response filter to the magnetic field measurements.

11. The method according to any preceding claim, comprising correcting the magnetic field measurements for time-based jitter.

12. The method according to any preceding claim, comprising filtering the magnetic field measurements to remove the geomagnetic field at the location of the unmanned aerial vehicle (100) from the magnetic field measurements.

13. The method according to any preceding claim, wherein the contribution to the magnetic field measurements from the rotor (106) has inconsistent phase and/or time-varying frequencies.

14. A control device (400) configured to filter magnetic field measurements generated by an optically pumped magnetometer (110, 210) mounted to an unmanned aerial vehicle (100), the control device (400) comprising:
a processor (402); and
instructions which, when executed by the processor (402), cause the processor to perform the method of any preceding claim.

15. An unmanned aerial vehicle (100) configured for use with a magnetic beacon, the unmanned aerial vehicle (100) comprising:
a rotor (106);
an optically pumped magnetometer (110, 210) configured to generate magnetic field measurements; and
a control device (400) according to claim 14.
